# EUROPÄISCHE PATENTSCHRIFT

(11) **EP 4 096 898 B1**
(45) Veröffentlichungstag und Bekanntmachung des Hinweises auf die Patenterteilung: **04.09.2024**
(21) Anmeldenummer: 21701732.6
(22) Anmeldetag: 21.01.2021
(51) Int. Cl.: B29C 64/124, B22F 12/00, B22F 10/00, B33Y 80/00, B33Y 70/10, B33Y 40/00, B33Y 30/00, B33Y 10/00, B29C 64/357, B29C 64/35, B29C 64/245, B29C 64/236, B29C 64/194, B29C 64/165, B22F 10/12, B22F 10/73, B29C 64/223

(54) **3D-DRUCKER ZUR ADDITIVEN FERTIGUNG EINES BAUTEILS UND DRUCKVERFAHREN**
3D PRINTER FOR THE ADDITIVE MANUFACTURE OF A COMPONENT, AND PRINTING METHOD
IMPRIMANTE 3D POUR LA FABRICATION ADDITIVE D'UNE PIÈCE ET PROCÉDÉ D'IMPRESSION

(30) Priorität: 29.01.2020 AT 5001420 U
(43) Veröffentlichungstag der Anmeldung: 07.12.2022
(73) Patentinhaber: TDK Electronics AG, 81671 München (DE)
(72) Erfinder: LENZEN, Thomas, 8010 Graz (AT); NEUREITER, Reinhard, 80469 München (DE); RECHER, Christoph, 8523 Frauental (AT)
(74) Vertreter: Epping - Hermann - Fischer
(86) Internationale Anmeldenummer: PCT/EP2021/051342
(87) Internationale Veröffentlichungsnummer: WO 2021/151777

(56) Entgegenhaltungen:
- US-A1- 2018 043 619
- US-A1- 2018 272 608

## Beschreibung

Die Erfindung betrifft einen 3D-Drucker zur additiven Fertigung eines mehrschichtigen Bauteils gemäß dem unabhängigen Anspruch 1 und ein Verfahren zur additiven Fertigung eines dreidimensionalen, mehrschichtigen Bauteils gemäß dem unabhängigen Anspruch 10.

Druckapparate für die Photopolymerisation im Bad (vgl. DIN EN ISO 17296)zeichnen sich dadurch aus, dass ein Rohmaterial in ein Bad hineingegeben oder auf eine sonstige Arbeitsfläche aufgetragen wird und anschließend in Kontakt mit einem mehrschichtigen Bauteil strukturiert und gehärtet wird. In einigen Verfahren wird das Rohmaterial Schicht für Schicht auf eine Arbeitsfläche aufgetragen. Übliche Methoden zur Strukturierung und Härtung des Rohmaterials sind Stereolithografie (SLA) oder Digital Light Processing (DLP). In diesen Verfahren wird das Rohmaterial von in der Regel programmierbaren digitalen Strahlungsquellen bestrahlt. SLA-Verfahren nutzen hierfür in der Regel schwenkbare Laser, während DLP-Verfahren beispielsweise Projektoren nutzen. Die Bestrahlung folgt einem vorbestimmten Muster. Das in diesem Fall photosensitive Rohmaterial härtet dann durch Photopolymerisation eines enthaltenen Bindemittels.

Die internationale Patentanmeldung WO 2015/107066 A1 offenbart einen DLP-3D-Drucker, in dem das Rohmaterial auf ein Förderband aufgetragen und von diesem zur Arbeitsfläche transportiert wird. Da in der Regel nur ein Teil des zur Verfügung stehenden Rohmaterials zur Strukturierung der neuen Schicht verbraucht wird, muss mehr Rohmaterial eingesetzt werden als für die Fertigung des Bauteils notwendig ist. Der eingesetzte Überschuss an Rohmaterial macht das Druckverfahren ineffizient und teuer.

In der internationalen Patentanmeldung WO 2017/009368 A1 wird ein weiterer 3D-Drucker mit Förderband offenbart. Das im Druckverfahren überbleibende Rohmaterial wird hier mittels einer Rückgewinnungsvorrichtung gesammelt und kann anschließend wieder in den Fertigungsprozess eingesetzt werden. Um mit einem zweiten Rohmaterial zu drucken, muss der gesamte Drucker umfassend die Rückgewinnungsvorrichtung gesäubert werden, um Rückstände des ersten Rohmaterials zu entfernen. Somit ist das Drucken eines Bauteils, welches mehrere Schichten verschiedener Materialien umfasst, nicht in einem Druckvorgang möglich.

Die US-Anmeldung US 2017/0182708 A1 offenbart einen 3D-Drucker mit einer sich lateral bewegenden Arbeitsfläche. Mit Hilfe mehrerer Rohmaterialspender können hier verschiedene Rohmaterialien aufgetragen werden. Die Arbeitsfläche und das Bauteil müssen vor jedem Materialwechsel gesäubert werden. Eine Rückgewinnung überschüssigen Rohmaterials ist in der offenbarten Vorrichtung nicht vorgesehen.

Weitere 3D-Drucker aus dem Stand der Technik werden beispielsweise von US 2018/272608 A1 und US 2018/043619 A1 offenbart.

US 2018/272608 A1 offenbart einen 3D-Drucker, der mehrere separate Spender für unterschiedliche Rohmaterialien umfasst. Das Rohmaterial wird auf ein Förderband aufgetragen und zu einer Arbeitseinheit transportiert, wo das Rohmaterial durch Bestrahlung aus einer Strahlungsquelle gehärtet werden kann.

Das unverbrauchte Rohmaterial fällt anschließend in einen dafür vorgesehenen Behälter unterhalb des Förderbands.

US 2018/043619 A1 offenbart einen 3D-Drucker, der zirkulär angeordnet einen Spender, eine Fertigungsvorrichtung und Rückgewinnungsvorrichtungen aufweist. Ein Förderband transportiert das Rohmaterial zum Bauteil. Durch eine Strahlungsquelle kann das Rohmaterial im Kontakt mit dem Bauteil gehärtet werden. Das übrige Rohmaterial wird durch das Förderband weiter zur Rückgewinnungsvorrichtung transportiert. Anschließend wird das Rohmaterial über die Rückführungsvorrichtung in den daneben angeordneten Spender zurücktransportiert.

Eine Vielzahl von Bauelementen sollen mehrere Schichten, die verschiedene Materialien umfassen, enthalten. Dies ist in der Regel nur mit aufwendigen Fertigungsverfahren möglich, in denen die einzelnen Bestandteile beispielsweise separat gedruckt werden und anschließend zusammengefügt werden. Zwar umfasst der Stand der Technik erste Ansätze zum Druck mehrschichtiger Bauelemente, die verschiedene Materialien umfassen, doch sind diese aufgrund des einzusetzenden Überschusses an Rohmaterial ineffizient und teuer.

Der 3D-Drucker umfasst weiterhin mindestens zwei getrennte Rückgewinnungsvorrichtungen zur selektiven Rückgewinnung des jeweils verschiedenen Rohmaterials, welches beim Anfügen einer Schicht an das Bauteil nicht verbraucht wird. Das rückgewonnene Rohmaterial wird anschließend in den jeweils zugehörigen Spender rückgeführt. Jedem Rohmaterial ist also zum einen ein Spender zugeordnet, der nur dieses eine Rohmaterial aufträgt, und zum anderen eine Rückgewinnungsvorrichtung zugeordnet, die nur dieses eine Rohmaterial rückgewinnt und in den zugehörigen Spender rückführt.

So kann sichergestellt werden, dass sich die verschiedenen Rohmaterialien weder während des Fertigungsvorganges, noch während der Rückführung miteinander vermischen. Das überschüssige Rohmaterial kann also in gleichbleibender Qualität rückgewonnen werden und wieder in den Fertigungsprozess eingesetzt werden. Ein Drucker kann so auf effiziente und ressourcenschonende Weise in einem Druckvorgang ein Bauteil mit mehreren Schichten verschiedener Materialien drucken.

Der Drucker umfasst weiterhin das Förderband, mit dem das Rohmaterial in einer lateralen Richtung vom Spender zur Fertigungseinheit und weiter zur Rückgewinnungsvorrichtung transportiert wird. Das Förderband ermöglicht es, den Ort der Materialzufuhr vom Ort der Fertigung und der Materialrückgewinnung zu entkoppeln. Somit ermöglicht das Förderband einen flexiblen Aufbau des Druckers.

In einer Ausführungsform, beinhalten die Speicher des Spenders eine Mischvorrichtung, mit welcher das zurückgeführte Rohmaterial und möglicherweise hinzugefügtes neues Rohmaterial durchmischt werden, um eine homogene Zusammensetzung einzelner gedruckter Schichten zu garantieren.

In einer Ausführungsform umfasst das Förderband eine strahlungsdurchlässige Folie, die von sich drehenden Walzen bewegt wird. Die Strahlungs-Durchlässigkeit des Förderbands ermöglicht das Härten des Rohmaterials per Bestrahlung mittels einer Strahlungsquelle auch durch das Förderband hindurch. In einer Ausführungsform kann die Folie eine beliebige Polymer-Folie, die eine hohe Strahlungs-Durchlässigkeit aufweist, sein. Unter Strahlung wird hier und im Folgenden sichtbares Licht, Licht im Infrarot(IR)- und Ultraviolett(UV)-Bereich, Röntgenstrahlung und sämtliche weitere Formen von elektromagnetischer Strahlung zusammengefasst.

Das Förderband kann weiterhin in einem Kreislauf zirkulieren und somit nach Vollendung einer vollen Zirkulation erneut beschichtet werden. Das Zirkulieren des Förderbands erspart z.B. bei Verwendung einer Folie das Zuführen ständig neuer Folie, sodass der Prozess ressourcenschonender und kostengünstiger durchgeführt werden kann.

Die während des Druckprozesses eingesetzten Rohmaterialien umfassen Pasten, die entweder ein keramisches oder ein metallisches oder ein organisches Pulver und ein photopolymeriserbares, also durch Strahlung polymerisierbares (Photopolymerisation), organisches Bindemittel beinhalten können. Ein solches Rohmaterial kann durch Bestrahlen strukturiert und gehärtet werden. Die Strahlung regt beispielsweise das photopolymerisierbare organische Bindemittel zur Polymerisation an, wodurch im Rohmaterial gehärtete Strukturen ausgebildet werden.

An das Drucken können sich ein Entbinderungsprozess und ein Sinterprozess anschließen. Diese Prozesse werden durchgeführt, um das organische Bindemittel zu entfernen und eine gewünschte Struktur im keramischen oder metallischen Bauelement einzustellen.

In einer Ausführungsform umfasst die Fertigungseinheit des 3D-Druckers Komponenten zur Fertigung des Bauteils gemäß eines DLP-Verfahrens oder eines SLA-Verfahrens.

In dieser Ausführungsform umfasst die Fertigungseinheit eine Arbeitsfläche, über die das Förderband geführt wird. Die Arbeitsfläche umfasst ein Fenster, welches strahlungsdurchlässig ist. Ferner umfasst die Fertigungseinheit eine Strahlungsquelle, die unter dem Fenster angeordnet ist. Somit kann die Strahlungsquelle durch das Fenster und das strahlungsdurchlässige Förderband hindurch, das Rohmaterial auf dem Förderband belichten und härten. Die Strahlungsquelle kann so gestaltet sein oder programmiert werden, dass sie das Rohmaterial in einem gewünschten Muster bestrahlt und härtet. Bei der Strahlungsquelle handelt es sich beispielsweise um einen Laser (SLA-Verfahren) oder einen Projektor (DLP-Verfahren). Es kann sich beispielsweise um elektromagnetische Strahlung im sichtbaren, UV- oder IR-Bereich handeln.

Weiterhin umfasst die Fertigungseinheit eine Bauplatte, an deren Unterseite das Bauteil hergestellt wird und das dort haftet, und die über der Arbeitsfläche parallel zu dieser angeordnet ist. Ein Positionierungssystem kann die Bauplatte normal zur Arbeitsfläche anheben und senken und so den Abstand zwischen der zuvor gedruckten Schicht des Bauteils und dem Förderband einstellen. Die erste Schicht wird direkt auf die Bauplatte gedruckt. Der eingestellte Abstand gibt dann die Dicke der an das Bauteil anzufügenden Schicht vor.

An der Bauplatte können auch mehrere Bauteile haften, an die parallel neue Schichten gefügt werden. Alle Bauteile müssen sich bei dieser Ausgestaltung über der Arbeitsfläche und innerhalb der Fläche des strahlungsdurchlässigen Fensters befinden.

In einer Ausführungsform umfasst die Fertigungseinheit eine Säuberungsvorrichtung zum Säubern des Bauteils von überschüssigem Rohmaterial. Die Säuberungsvorrichtung kann ein Antriebssystem umfassen, mit dessen Hilfe die Säuberungsvorrichtung lateral entlang der Oberfläche des Bauteils bewegt werden kann.

Bei der Säuberungsvorrichtung kann es sich beispielweise um eine Saugdüse, eine Klinge oder eine Walze handeln. Die Säuberungsvorrichtung ist bevorzugt so angeordnet, dass sie im passiven Zustand lateral neben dem Bauteil positioniert ist und sich im aktiven Zustand lateral über die Oberfläche des Bauteils bewegen kann.

Für jedes Rohmaterial kann eine separate Säuberungsvorrichtung vorgesehen sein, sodass die Fertigungseinheit mindestens zwei Säuberungsvorrichtungen umfasst.

Jede Säuberungsvorrichtung umfasst eine Rückführeinrichtung, wobei jede Rückführeinrichtung eine Fördereinrichtung umfasst, die das zurückgewonnene Rohmaterial in den jeweils zugeordneten Spender rückführt. Die Fördereinrichtung ist beispielsweise eine Pumpe und die Rückführeinrichtung ein Schlauch. Die getrennten Rückführeinrichtungen stellen sicher, dass das Rohmaterial nicht vermischt wird und somit wieder eingesetzt werden kann.

In einer Ausführungsform kann die Rückführeinrichtung mit der Säuberungsvorrichtung identisch sein. Zum Beispiel kann eine Walze verwendet werden, die eine haftende Oberfläche aufweist und durch ein Abfahren der Bauteiloberfläche darauf zurückgebliebenes Rohmaterial entfernt. Anschließend kann die Walze durch ein Positionierungssystem zum Spender bewegt werden, wo das Rohmaterial von der Walze entfernt und in den Spender gefüllt wird. Eine solche Vorrichtung wird Walzentransferapparat genannt.

Ähnliches kann mit Hilfe einer haftenden Oberfläche eines Transferfilms ausgeführt werden. Handelt es sich bei der Säuberungsvorrichtung um eine Saugdüse kann die Rückführeinrichtung als Schlauch ausgeführt sein, welcher beispielsweise als Fördereinrichtung eine Pumpe oder ein Gebläse enthält. Bei Ausführung der Säuberungsvorrichtung als Klinge, die über die Oberfläche des Bauteils schabt, kann die Rückführeinrichtung eine unter dem Bauteil befindliche Wanne sein, die mit Hilfe eines Positionierungssystems zum Spender bewegt werden kann.

Die Erfindung offenbart weiterhin ein Verfahren zur additiven Fertigung eines dreidimensionalen mehrschichtigen Bauteils und zur Rückgewinnung von unverbrauchtem Rohmaterial, welches die folgenden Schritte umfasst:
- Aufbringen einer Schicht eines Rohmaterials auf ein Förderband mittels eines Spenders, wobei die aufgebrachte Schichtdicke an Rohmaterial mindestens der gewünschten Schichtdicke einer an das Bauteil zu addierenden Schicht entspricht.

In der Regel ist ein Überschuss an Rohmaterial erforderlich, um eine unversehrte Schicht mit den gewünschten Maßen zu fertigen.
- Transport des Förderbands mit der Schicht des Rohmaterials auf eine Arbeitsfläche.

Das Förderband ermöglicht die Entkopplung des Orts der Aufbringung des Rohmaterials und des Orts der Fertigung und macht das Verfahren somit flexibler.
- In Kontakt bringen der Schicht des Rohmaterials mit einer zu beschichtenden Oberfläche des Bauteils auf der Arbeitsfläche und strukturiertes Härten eines Teils des Rohmaterials zur Ausbildung einer neuen strukturierten Schicht des Bauteils.

Die erste Schicht des Bauteils wird in Kontakt mit der Oberfläche einer dafür vorgesehenen Bauplatte gefertigt.
- Abheben des die neue Schicht umfassenden Bauteils von der Arbeitsfläche.

Durch das Abheben wird das gehärtete Bauteil von nicht gehärtetem Rohmaterial getrennt. Es ist möglich, dass ein Teil des überschüssigen Rohmaterials am Bauteil haften bleibt.
- Transport des übrigen Rohmaterials auf dem Förderband zu einer Rückgewinnungsvorrichtung.

Die Rückgewinnungsvorrichtung kann beispielsweise als Saugdüse, Klinge oder Walze ausgeführt sein und weiterhin eine Vorrichtung zur Rückführung des Rohmaterials in den Spender umfassen.
- Entfernen des übrigen Rohmaterials vom Förderband mit Hilfe der Rückgewinnungsvorrichtung und Rückführung des Rohmaterials zu einem Spender.

Die Einrichtung zur Rückführung kann beispielsweise ein Schlauch- oder Rohrsystem sein. Dieses kann eine Fördereinrichtung, wie beispielsweise eine Pumpe oder ein Gebläse umfassen.

Handelt es sich bei der Rückgewinnungsvorrichtung um eine Walze, kann diese als Transferwalzenmaschine ausgeführt sein. Die Transferwalze nimmt über ihre haftende Oberfläche Rohmaterial auf, kann anschließend zum Spender bewegt werden, und gibt dort das Rohmaterial wieder an den entsprechenden Spender ab.
- Wiederholen der zuvor genannten Verfahrensschritte mit einem zweiten Rohmaterial und einem zweiten Spender, wobei eine zweite Rückgewinnungsvorrichtung vorgesehen ist, sodass das erste und zweite Rohmaterial jeweils selektiv in den entsprechenden Spender rückgeführt werden kann.

In weiterer Ausgestaltung des Verfahrens werden die zuvor genannten Verfahrensschritte mit einem dritten oder weiteren Rohmaterialien und einem dritten oder weiteren Spendern, sowie dritten oder weiteren Rückgewinnungsvorrichtungen wiederholt. Das dritte Rohmaterial wird selektiv in den entsprechenden Spender rückgeführt. Auch die weiteren Rohmaterialien werden jeweils selektiv in die entsprechenden weiteren Spender rückgeführt. Es findet keine Vermischung der Rohmaterialien statt, sodass diese wieder in das Druckverfahren eingesetzt werden können.

In einer Ausführung des Verfahrens, weist die Arbeitsfläche ein Fenster auf, das strahlungsdurchlässig ist. In seiner Abmessung weist das Fenster mindestens die Ausmaße der zu addierenden Schicht auf. Eine Bauplatte mit dem Bauteil wird über dem Fenster positioniert. Die Bauplatte wird normal zum Fenster abgesenkt bis die Distanz zwischen der Oberfläche des Bauteils und der Oberseite des Förderbands der gewünschten Schichtdicke der neuen, an das Bauteil zu addierenden strukturierten Schicht entspricht. Beim Druck der ersten Schicht des Bauteils wird die Bauplatte so abgesenkt, dass der Abstand zwischen der Oberfläche der Bauplatte und dem Förderband der gewünschten Dicke der ersten Schicht entspricht.

In diesem Verfahren wird das Rohmaterial mittels Bestrahlung des mehrschichtigen Bauteils durch das Fenster zu einer neuen Schicht strukturiert und gehärtet. Hierfür umfasst das Rohmaterial ein Bindemittel, welches photosensitive Eigenschaften hat. Durch die Bestrahlung wird eine Photopolymerisation des Bindemittels hervorgerufen.

In dem Verfahren wird weiterhin die Bauplatte mit dem Bauteil und der daran haftenden neuen Schicht vom Förderband abgehoben. Hierzu soll die Haftung zwischen Bauteil und Bauplatte größer sein als die Haftung zwischen Bauteil und Förderband. Diese größere Haftung des Bauteils an der Bauplatte wird durch Auswahl des Materials der Bauplatte und durch eine hohe Oberflächenrauigkeit der Bauplatte im Vergleich zur Folie sichergestellt. Eine hohe Rauigkeit erleichtert eine Haftung des Bauteils an der Bauplatte. Bei Auswahl des Bauplattenmaterials ist bevorzugt ein Material mit ähnlichen Eigenschaften wie das Material des Bauteils zu wählen oder eine raustrukturierte Metallplatte.

In einem Verfahren, werden die folgenden anschließenden Schritte ausgeführt:
- Bereitstellen einer Säuberungsvorrichtung zum Säubern des Bauteils von Rohmaterial.

Die Säuberungsvorrichtung ist hier bevorzugt lateral neben dem Bauteil positioniert.
- Entfernen des überschüssigen Rohmaterials von der Oberfläche des Bauteils durch laterale Bewegung der Säuberungsvorrichtung entlang der Oberfläche des Bauteils.

Die Säuberungsvorrichtung kann beispielsweise eine Saugdüse, eine Klinge oder eine Walze sein.
- Rückführung des Rohmaterials in den dem Rohmaterial entsprechenden Spender durch eine zugehörige Rückführeinrichtung.

Im Falle der Saugdüse kann die Rückführeinrichtung beispielsweise ein Schlauch- oder ein Rohrsystem sein. Im Falle der Walze kann es sich um eine Transferwalzenmaschine handeln. Jedem Rohmaterial wird eine entsprechende Säuberungsvorrichtung mit entsprechender Rückführeinrichtung zugewiesen, sodass die Rohmaterialien nicht vermischt werden.

Die Erfindung umfasst weiterhin ein Bauteil, welches mehrere Schichten umfasst, die
- entlang einer ebenen Fläche voneinander abgegrenzt sind,
- unterschiedliche Materialien umfassen,
- chemisch direkt miteinander verbunden sind, und

Die Erfindung umfasst weiterhin ein Bauteil mit den zuvor genannten Eigenschaften, dessen Schichten jeweils eine Dicke von maximal 300 um aufweisen. Bevorzugt weist ein Bauteil Schichtdicken zwischen 5 um und 200 um auf.

Die Schichten können sowohl lateral wie auch vertikal nebeneinander angeordnet sein. Die abgrenzenden Flächen zwischen unterschiedlichen Schichten können parallel zu den äußeren Oberflächen des Bauteils verlaufen. Die Materialien des Bauteils können verschiedene Metalle, Keramiken und Kunststoffe umfassen oder eines von diesen. Es sind keine zusätzlichen Verbindungsmittel, wie beispielsweise Klebstoffe, zwischen den einzelnen Schichten vorgesehen. Die Schichtdicken können im Druckverfahren variabel angepasst werden, sodass eine flexible Strukturierung des Bauteils möglich ist.

In einer Ausführungsform, liegt das Bauteil nach dem Drucken in einer ersten Struktur vor und umfasst ein Bindemittel. Im Fall von reinen Kunststoffbauteilen ist diese erste Struktur die gewünschte Bauteilstruktur. Im Falle von Metall- bzw. Keramik-Bauteilen kann durch einen Sinterschritt das Bindemittel entfernt und die Struktur des Bauteils verändert werden. Nach dem Sintern liegt das Bauteil in einer gewünschten zweiten Struktur vor.

Die Erfindung wird nachfolgend in Ausführungsbeispielen anhand von Zeichnungen näher erläutert. Die Erfindung ist aber nicht auf die beschriebenen oder dargestellten Formen und Beispiele beschränkt. Der Schutzumfang richtet sich nur nach den in den Ansprüchen offenbarten Merkmalen.

Die Zeichnungen zeigen:
Figur 1 Schematische Darstellung einer ersten Ausführungsform des 3D-Druckers. Dargestellt ist der Fertigungsschritt.
Figuren 2A, 2B, 2C, 2D, 2E und 2F Schematische Abbildung eines Druckverfahrens anhand des ersten Ausführungsbeispiels des 3D-Druckers.
Figur 3 Schematische Darstellung eines zweiten Ausführungsbeispiels des 3D-Druckers, bei dem die Folie im Kreislauf zirkuliert wird.
Figur 4 Schematische Darstellung eines gedruckten, mehrschichtigen Bauteils.

Bei den Figuren handelt es sich um schematische Darstellungen. Die Figuren stellen keine maßstabsgerechten Abbildungen des 3D-Druckers dar. Dimensionen und Größenverhältnisse können von der in den Zeichnungen gezeigten Darstellungen abweichen.

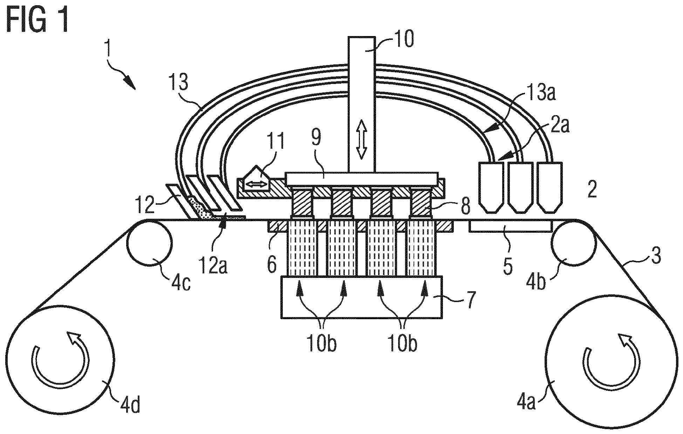

Figur 1 zeigt ein erstes Ausführungsbeispiel des 3D-Druckers 1. Der 3D-Drucker 1 umfasst drei getrennte Spender 2, die nebeneinander angeordnet sind. Die Spender 2 sind über einem Förderband 3 angeordnet, und so ausgebildet, dass sie auf das Förderband jeweils verschiedene Rohmaterialien auftragen können. Die Spender 2 sind hier als Düsenbeschichter ausgeführt.

Das Förderband 3 umfasst eine über mehrere Walzen 4 geführte Folie. Die Folie besteht aus einem Polymer wie beispielsweise Polyethylenterephthalat (PET). Die vier dargestellten Walzen 4 drehen sich im vorliegenden Beispiel in gleicher Geschwindigkeit gegen den Uhrzeigersinn und bewegen so das Förderband 3. Die Folie ist vor dem Drucken auf der ganz rechts dargestellten Walze 4a aufgerollt und wird von dieser im Laufe des Prozesses abgerollt, bevor sie von einer ersten Umlenkrolle 4b in eine gewünschte Richtung abgelenkt wird und den 3D-Drucker 1 durchläuft

Nach Durchlaufen des 3D-Druckers 1 wird die Folie von einer zweiten Umlenkrolle 4c in Richtung einer in Figur 1 ganz links dargestellten Walze 4d umgelenkt und dort wieder aufgerollt. Eine Rückführung der Folie zur Wiederverwertung ist möglich, wenn die linke und die rechte Walze, 4a und 4d nach Ende des Prozesses ausgetauscht werden.

Zur Unterstützung der Folie ist an der Stelle der Rohmaterialauftragung eine Trägerplatte 5 unter der Folie, auf der den Spendern 2 gegenüberliegenden Seite angebracht. Die Trägerplatte 5 und die Folie sind nicht miteinander verbunden. Die Folie liegt lose auf der Trägerplatte 5 auf. Das Förderband dient zum Transport des durch die Spender aufgetragenen Rohmaterials zu einer lateral neben der Trägerplatte 5 angeordneten Arbeitsfläche 6. Die Folie liegt ebenso lose auf der Arbeitsfläche 6 auf.

Die Arbeitsfläche 6 enthält ein strahlungsdurchlässiges Fenster, das den größten Teil der Fläche einnimmt. Unterhalb des Fensters ist ein Projektor 7 angeordnet, der das Rohmaterial zwischen der Folie und den Bauteilen 8, das als neue Schicht an die Bauteile 8 addiert werden soll, in einem vorgegebenen Muster bestrahlt und dadurch strukturiert und härtet. Beispielhafte Lichtstrahlen 10b sind in der Figur dargestellt. Das Muster kann beispielsweise in Form einer auf den Projektor 7 aufgesetzten Maske definiert werden. Alternativ kann das Muster beispielsweise digital vorprogrammiert sein.

Das Muster kann so gestaltet sein, dass die neue Schicht nach dem Aufdrucken auf das Bauteil nur einen Bereich der Unterseite des bisherigen Bauteils 8 bedeckt. In einem späteren Druckvorgang kann somit auch eine weitere Schicht lateral neben eine bestehende Schicht gedruckt werden.

Mehrere Bauteile 8 sind an einer Bauplatte 9 angebracht. Die Anzahl der möglichen angebrachten Bauteile 8 hängt von der Geometrie der Bauteile 8 und der Bauplatte 9 ab. Im vorliegenden Beispiel sind vier Bauteile 8 an der Bauplatte 9 angebracht. Die Bauplatte 9 umfasst eine Unterseite mit hoher Oberflächenrauigkeit, an der die Bauteile 8 gut haften. Die Bauplatte 9 ist parallel zur Arbeitsfläche 6 über dieser angeordnet. Anhand eines Positionierungssystems 10 kann die Bauplatte 9 mit den Bauteilen 8 normal zur Arbeitsfläche 6 gehoben und gesenkt werden. Dazu ist das Positionierungssystem 10 mittig über der Arbeitsfläche 6 und vertikal zu dieser positioniert.

Weiterhin umfasst der 3D-Drucker 1 eine Säuberungsvorrichtung 11, die mit Hilfe eines Antriebssystems entlang der Unterseiten der Bauteile 8 bewegt werden kann. Das besagte Antriebssystem ist daher parallel zur Bauplatte 9 in genügend großem Abstand über der Arbeitsfläche 6 und vor bzw. hinter dem Positionierungssystem 10 positioniert. Die Säuberungsvorrichtung 11 ist in diesem Fall als Klinge ausgeführt, die unverbrauchtes Rohmaterial von den Bauteilen 8 abschaben kann.

Weiterhin umfasst der 3D-Drucker 1 im ersten Ausführungsbeispiel drei Rückgewinnungsvorrichtungen 12. Die Rückgewinnungsvorrichtungen 12 sind als Klingen ausgeführt, die das überflüssige Rohmaterial vom sich bewegenden Förderband 3 schaben. Für jedes Rohmaterial ist eine separate Rückgewinnungsvorrichtung 12 vorgesehen. Die Rückgewinnungsvorrichtungen 12 sind über einem Abschnitt des Förderbandes 3 angebracht, der sich lateral neben der Arbeitsfläche 6, aber an einer anderen Seite als die Trägerplatte 5 befindet.

Die Rückgewinnungsvorrichtungen 12 umfassen weiter jeweils einen Schlauch 13, zur Rückführung des Rohmaterials in den zugehörigen Spender 2. Im Schlauch 13 ist eine Pumpe vorgesehen, die das Rohmaterial von der Rückgewinnungsvorrichtung 12 ansaugt und durch den Schlauch 13 fördert. Die Schläuche 13 verbinden die Rückgewinnungsvorrichtungen 12 mit den jeweils zugehörigen Spendern 2.

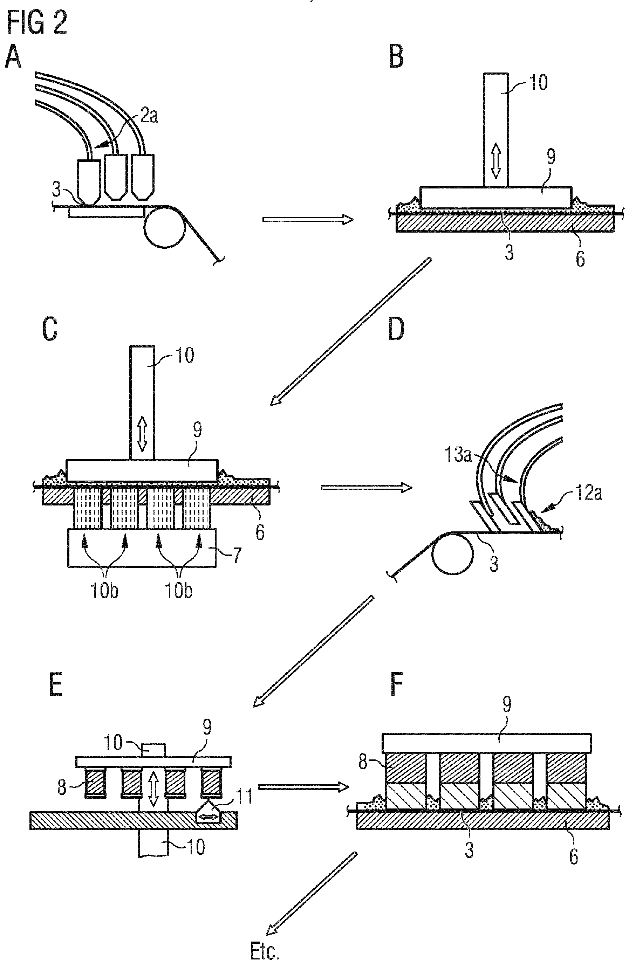

Ein beispielhaftes Verfahren wird in den Figuren 2A, 2B, 2C, 2D, 2E und 2F anhand des ersten Ausführungsbeispiels dargestellt. In einem ersten Schritt A trägt ein erster Spender 2a ein erstes Rohmaterial auf das Förderband 3 auf. Das Förderband 3 transportiert das Rohmaterial auf die Arbeitsfläche 6.

Anschließend wird vom Positionierungssystem 10 die Bauplatte 9 in einem Schritt B so weit gesenkt, dass die Bauplatte in Kontakt mit dem auf dem Förderband aufgetragenen Rohmaterial tritt und der Abstand zwischen Bauplatte 9 und Förderband 3 der gewünschten Dicke der neuen Schicht entspricht. Überflüssiges Rohmaterial wird hier beim Drucken der ersten Schicht an die Ränder der Bauplatte 9 verdrängt.

Anschließend wird im Schritt C das Rohmaterial unter der Bauplatte 9 von einem Projektor 7 gemäß einem gewünschten Muster oder einer gewünschten Struktur bestrahlt. Durch einfallende Strahlung härtet das Material durch Photopolymerisation des organischen Bindemittels und bildet eine erste Schicht der Bauteile 8, die an der Bauplatte 9 haften bleibt. Die Bauplatte 9 kann nun mit Hilfe des Positionierungssystems 10 angehoben werden, wobei der Großteil des übrigen nicht gehärteten Rohmaterials auf dem Förderband 3 zurückbleibt.

Das übrige auf dem Förderband 3 verbliebene und nicht auf die Bauplatte bzw. das Bauteil übertragene Rohmaterial wird von diesem im Schritt D weiter transportiert und von einer ersten Rückgewinnungsvorrichtung 12a, die als Klinge ausgeführt ist, vom Förderband 3 entfernt. Der Schlauch 13a fördert das Rohmaterial anschließend angetrieben durch eine in den Schlauch 13a integrierte Pumpe in den ersten Spender 2a zurück.

Parallel zur Rückgewinnung kann analog zu Schritt A bereits neues Rohmaterial auf das Förderband 3 aufgetragen werden. Hierbei kann es sich um denselben Spender wie in Schritt A handeln, der dasselbe Rohmaterial aufträgt, oder um einen anderen Spender, der ein anderes Rohmaterial aufträgt. Das Förderband transportiert dann zeitgleich altes, unverbrauchtes Rohmaterial von der Arbeitsfläche 6 weg zur ersten Rückgewinnungsvorrichtung 12a und neues Rohmaterial von einem der Spender 2 zur Arbeitsfläche 6.

Parallel wird in Schritt E nach dem Anheben der Bauplatte 9 mit den daran haftenden Bauteilen 8 die Unterseite der neu gedruckten Schicht durch Abfahren der Oberfläche des Bauteils 8 mit der Säuberungsvorrichtung 11 gesäubert.

Das Rohmaterial wird ebenfalls in den zugehörigen ersten Spender 2a rückgeführt.

Sobald die erste Schicht gedruckt und gesäubert worden ist und das erste Rohmaterial vollständig vom Förderband 3 entfernt worden ist, kann eine zweite und dann weitere Schichten durch Wiederholen der genannten Verfahrensschritte mit gegebenenfalls anderer gehärteter Struktur auf das Bauteil 8 aufgebracht werden. Ist für die zweite oder eine weitere Schicht ein anderes Rohmaterial vorgesehen, werden der erste Spender 2a und die erste Rückgewinnungsvorrichtung 12a angehoben und stattdessen ein zweiter oder alternativ ein dritter Spender und eine zweite oder entsprechend dritte Rückgewinnungsvorrichtung zum Förderband 3 gesenkt und das gesamte Verfahren mit einem weiteren Rohmaterial wiederholt.

Da dann bereits mindestens eine Schicht des Bauteils 8 an der Bauplatte 9 haftet, wird in einem dem Schritt B entsprechenden Schritt F das Bauteil 8 so weit gesenkt, dass der Abstand zwischen Bauteil 8 und Förderband 3 der Dicke einer gewünschten neuen Schicht entspricht. Überflüssiges Rohmaterial wird dabei nun an die Ränder der bestehenden Schichten der Bauteile 8 verdrängt.

Das erste Rohmaterial ist zum Beispiel ein keramisches Rohmaterial, welches ein organisches Bindemittel enthält. Das zweite Rohmaterial, in der Figur 2F schraffiert dargestellt, ist beispielsweise eine Polymerpaste, welche ebenfalls das organische Bindemittel enthält. Weitere Schichten können wieder dieselben oder weitere unterschiedliche Rohmaterialien enthalten. Jede Schicht kann mit unterschiedlicher Struktur bzw. als unterschiedliches Muster aufgebracht werden, so dass die Herstellung eines Bauteils mit beliebiger äußerer Raumform und beliebiger innerer Struktur erzeugt werden kann.

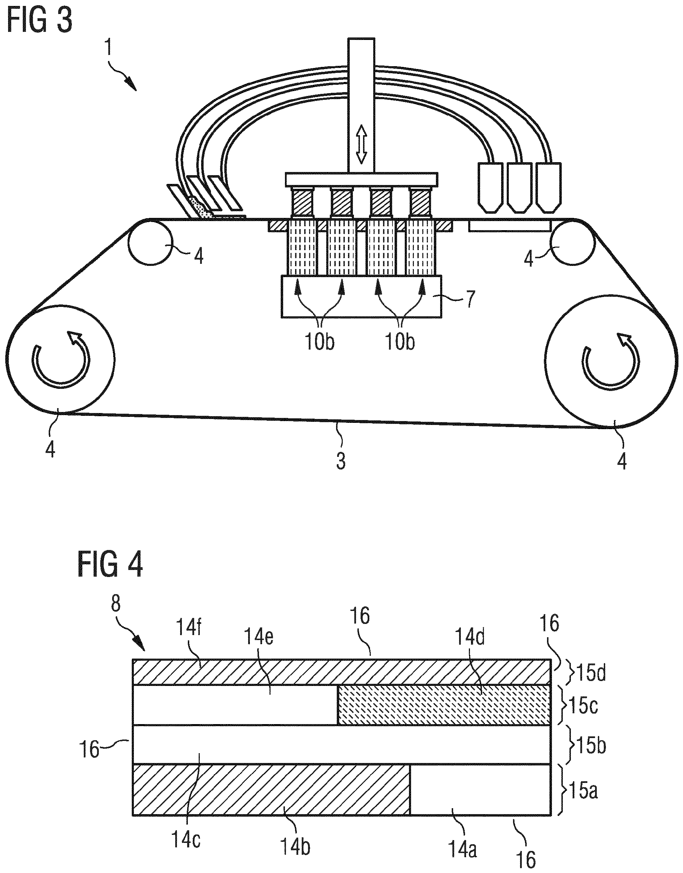

Abbildung 3 zeigt eine zweite Ausführungsform des 3D-Druckers 1, die im Wesentlichen dem ersten Ausführungsbeispiel entspricht. Im Unterschied zur ersten Ausführungsform wird bei der zweiten Ausführungsform das Förderband 3 jedoch im Kreislauf geführt, sodass die für das Förderband 3 verwendete Folie zirkulierend, ohne Unterbrechung oder Eingreifen in das Verfahren wieder verwendet werden kann. Das Förderband 3 wird hierfür über vier Walzen 4 geführt, die sich im vorliegenden Beispiel in geeigneter Geschwindigkeit gegen den Uhrzeigersinn drehen. Die Walzen können sich in anderen Ausführungsbeispielen auch im Uhrzeigersinn drehen. Die Anordnung der Walzen 4 entspricht der Anordnung der vier Walzen des ersten Ausführungsbeispiels. Im Unterschied dazu dienen nun alle Walzen als Umlenkrollen. Die Folie wird auf keiner Walze ab- oder aufgewickelt.

In einem bevorzugten Ausführungsbeispiel ist entlang des im Kreislauf geführten Förderbandes 3 hinter der Rückgewinnungsvorrichtung eine Reinigungsvorrichtung vorgesehen, die letzte Reste an Rohmaterial vom Förderband 3 entfernt, sodass sichergestellt ist, dass es zu keinem Vermischen der verschiedenen Rohmaterialien kommt.

Figur 4 zeigt beispielhaft und schematisch ein gedrucktes, mehrschichtiges Bauteil 8. Das Bauteil umfasst hier sechs Schichten 14a bis 14f in vier vertikal gestapelten Ebenen 15a bis 15d. Die erste und die dritte Ebene (15a, 15c) von unten umfassen jeweils zwei Schichten (14a, 14b, 14d, 14e). Die oberste Schicht 14f entspricht der im Druckprozess zuerst gefertigten Schicht. Die untersten Schichten 14a und 14b wurden im Druckprozess zuletzt gefertigt.

Das Bauteil 8 umfasst Schichten dreier unterschiedlicher Materialien, die durch unterschiedliche Schraffuren dargestellt sind. Eines der drei Materialien ist ein Metall, die andern sind zwei unterschiedliche Polymere oder Keramiken.

Die Abgrenzung zwischen den Schichten verläuft jeweils entlang einer ebenen Grenzfläche parallel zu den Außenseiten 16 des Bauteils 8. Die einzelnen Schichten können eine horizontale Ebene des Bauteils 8 voll umfassen, wie die zweite und vierte Schicht (14c, 14f) von unten im vorliegenden Bauteil 8. Die Schichten können aber auch lateral nebeneinander vorliegen wie in der ersten und dritten Ebene (15a, 15c) des Bauteils 8.

Die Schichtdicken des Bauteils 8 können variieren. Die oberste Schicht 14f im dargestellten Bauteil 8 ist dünner, die untersten beiden Schichten 14a und 14b sind dicker als die übrigen Schichten des Bauteils 8.

Zwischen den beschriebenen Schichten existieren keine weiteren Zwischenschichten oder Verbindungsschichten, wie beispielsweise Klebeschichten.

### Bezugszeichen

- 1: 3D-Drucker
- 2: Spender
- 2a: erster Spender
- 3: Förderband
- 4: Walzen des Förderbandes 3
- 4a: rechte Walze
- 4b: erste Umlenkrolle
- 4c: zweite Umlenkrolle
- 4d: linke Walze
- 5: Trägerplatte
- 6: Arbeitsfläche
- 7: Projektor
- 8: Bauteil
- 9: Bauplatte
- 10: Positionierungssystem
- 10b: Lichtstrahl
- 11: Säuberungsvorrichtung
- 12: Rückgewinnungsvorrichtung
- 12a: erste Rückgewinnungsvorrichtung
- 13: Schlauch
- 13a: erster Schlauch
- 14a-14f: Schichten des Bauteils 8
- 15a-15d: Ebenen des Bauteils 8
- 16: Außenseite des Bauteils 8

## Patentansprüche

1. 3D-Drucker (1) zur additiven Fertigung eines mehrschichtigen Bauteils, umfassend
- mindestens zwei getrennte Spender (2), die dazu ausgestaltet sind, ein Förderband (3) mit jeweils verschiedenem Rohmaterial zu beschichten,
- eine Fertigungseinheit, die dazu ausgestaltet ist, dass in der Fertigungseinheit zumindest ein Teil des Rohmaterials als neue Schicht an das Bauteil (8) gefügt wird,
- mindestens zwei getrennte Rückgewinnungsvorrichtungen (12) zur selektiven Rückgewinnung des jeweils verschiedenen Rohmaterials, welches beim Anfügen einer Schicht an das Bauteil (8) nicht verbraucht wird, und zur Rückführung des Rohmaterials in den jeweils zugehörigen Spender (2),
- das Förderband (3), das dazu ausgestaltet ist, das Rohmaterial vom Spender (2) zur Fertigungseinheit und weiter zur Rückgewinnungsvorrichtung (12) in lateraler Richtung zu transportieren.

2. 3D-Drucker (1) nach Anspruch 1, wobei das Förderband (3) eine strahlungsdurchlässige Folie umfasst, wobei sich drehende Walzen zur Bewegung der Folie ausgestaltet sind.

3. 3D-Drucker (1) nach Anspruch 2, in dem die Folie in einem Kreislauf zirkulieren kann und so erneut beschichtet werden kann.

4. 3D-Drucker (1) nach einem der Ansprüche 1 bis 3, wobei jedes der Rohmaterialien eine Paste umfasst, die ein entweder keramisches oder metallisches oder organisches Pulver und ein photopolymerisierbares organisches Bindemittel umfasst.

5. 3D-Drucker (1) nach einem der Ansprüche 1 bis 4, wobei jeder Spender (2) einen Behälter zum Speichern des Rohmaterials und eine Beschichtungsvorrichtung zur Beschichtung des Förderbandes (3) mit dem Rohmaterial umfassen.

6. 3D-Drucker (1) nach einem der Ansprüche 1 bis 5, wobei die Fertigungseinheit die folgenden Komponenten umfasst:
- eine Arbeitsfläche (6), über die das Förderband (3) geführt ist, und die ein Fenster umfasst, welches durchlässig für Strahlung ist,
- eine Strahlungsquelle (7), die unter dem Fenster angeordnet ist, sodass sie durch das Fenster und das Förderband (3) hindurch, das Rohmaterial auf dem Förderband belichten und somit härten kann,
- eine Bauplatte (9), an deren Unterseite das Bauteil (8) haftet, die über der Arbeitsfläche (6) parallel zu dieser angeordnet ist, und
- ein Positionierungssystem (10), welches die Bauplatte (9) normal zur Arbeitsfläche anheben und senken kann und zur Einstellung des Abstands zwischen Bauteil (8) und Förderband (3) ausgebildet ist.

7. 3D-Drucker (1) nach einem der Ansprüche 1 bis 6, wobei die Fertigungseinheit mindestens zwei Säuberungsvorrichtungen (11) zum Säubern des Bauteils (8) vom jeweils zugehörigen Rohmaterial umfasst.

8. 3D-Drucker (1) nach Anspruch 7, wobei die Säuberungsvorrichtungen (11) von einem Antriebssystem lateral entlang der Oberfläche des Bauteils (8) bewegt werden können.

9. 3D-Drucker (1) nach Anspruch 7 oder 8, wobei eine Rückführeinrichtung für jede der Säuberungsvorrichtungen (11) vorgesehen ist,
und wobei jede Rückführeinrichtung (11) eine Fördereinrichtung umfasst, die dazu ausgestaltet ist, das zurückgewonnene Rohmaterial in den jeweils zugeordneten Spender (2) rückzuführen.

10. Verfahren zur additiven Fertigung eines dreidimensionalen, mehrschichtigen Bauteils (8) und zur Rückgewinnung von unverbrauchtem Rohmaterial, welches die folgenden Schritte umfasst:
- Aufbringen einer Schicht eines Rohmaterials auf ein Förderband (3) mittels eines Spenders (2), wobei die aufgebrachte Schichtdicke an Rohmaterial mindestens der gewünschten Schichtdicke einer an das Bauteil (8) zu addierenden Schicht entspricht,
- Transport des Förderbands (3) in lateraler Richtung mit der Schicht des Rohmaterials auf eine Arbeitsfläche (6),
- in Kontakt bringen der Schicht des Rohmaterials mit einer zu beschichtenden Oberfläche des Bauteils (8) auf der Arbeitsfläche (6) und strukturiertes Härten eines Teils des Rohmaterials zur Ausbildung einer neuen strukturierten Schicht des Bauteils (8),
- Abheben des die neue Schicht umfassenden Bauteils (8) von der Arbeitsfläche (6),
- Transport des übrigen Rohmaterials auf dem Förderband (3) in lateraler Richtung zu einer Rückgewinnungsvorrichtung (12),
- Entfernen des übrigen Rohmaterials vom Förderband (3) mithilfe der Rückgewinnungsvorrichtung (12) und Rückführung des Rohmaterials zu einem Spender (2),
- Wiederholen der zuvor genannten Verfahrensschritte mit einem zweiten Rohmaterial und einem zweiten Spender (2), wobei eine zweite Rückgewinnungsvorrichtung (12) vorgesehen ist, so dass das erste und zweite Rohmaterial jeweils selektiv in den entsprechenden Spender (2) rückgeführt werden kann.

11. Verfahren nach Anspruch 10, wobei
- die Arbeitsfläche (6) ein Fenster aufweist, das strahlungsdurchlässig ist und in seiner Abmessung mindestens die Ausmaße der zu addierenden Schicht aufweist,
- eine Bauplatte mit dem Bauteil (8) über dem Fenster positioniert wird,
- die Bauplatte (9) normal zum Fenster abgesenkt wird bis die Distanz zwischen der Oberfläche des Bauteils (8) und der Oberseite des Förderbands (3) der gewünschten Schichtdicke der neuen an das Bauteil (8) zu addierenden strukturierten Schicht entspricht,
- das Rohmaterial mittels Bestrahlung des mehrschichtigen Bauteils (8) durch das Fenster zu einer neuen Schicht strukturiert und gehärtet wird, und
- die Bauplatte mit dem Bauteil (8) und der daran haftenden neuen Schicht vom Förderband (3) abgehoben wird.

12. Verfahren nach Anspruch 11, welches die folgenden anschließenden Schritte umfasst:
- Bereitstellen einer Säuberungsvorrichtung (11) zum Säubern des Bauteils (8) von Rohmaterial,
- Entfernen des überschüssigen Rohmaterials von der Oberfläche des Bauteils (8) durch laterale Bewegung der Säuberungsvorrichtung (11) entlang der Oberfläche des Bauteils (8),
- Rückführung des Rohmaterials in den dem Rohmaterial entsprechenden Spender (2) durch eine zugehörige Rückführeinrichtung.

## Claims

1. 3D printer (1) for additively manufacturing a multi-layer component, comprising
- at least two separate dispensers (2) which are designed to coat a conveyor belt (3) with respectively different raw material,
- a manufacturing unit which is designed such that, in the manufacturing unit, at least a portion of the raw material is joined as a new layer to the component (8),
- at least two separate recovery apparatuses (12) for selectively recovering the respectively different raw material which is not consumed when joining a layer to the component (8), and for recycling the raw material into the respectively associated dispenser (2),
- the conveyor belt (3) which is designed to transport the raw material in a lateral direction from the dispenser (2) to the manufacturing unit and onward to the recovery apparatus (12).

2. 3D printer (1) according to Claim 1, wherein the conveyor belt (3) comprises a radiation-permeable film, wherein rotating rollers are designed to move the film.

3. 3D printer (1) according to Claim 2, in which the film can circulate in a circuit and can thus be recoated.

4. 3D printer (1) according to one of Claims 1 to 3, wherein each of the raw materials comprises a paste which comprises an either ceramic or metallic or organic powder and a photopolymerizable organic binder.

5. 3D printer (1) according to one of Claims 1 to 4, wherein each dispenser (2) comprises a container for storing the raw material and a coating apparatus for coating the conveyor belt (3) with the raw material.

6. 3D printer (1) according to one of Claims 1 to 5, wherein the manufacturing unit comprises the following component parts:
- a working surface (6), over which the conveyor belt (3) is guided, and which comprises a window which is permeable to radiation,
- a radiation source (7) which is arranged under the window such that it can subject the raw material on the conveyor belt to exposure through the window and the conveyor belt (3) and thus cure said raw material,
- a building plate (9), to the bottom side of which the component (8) adheres, and which is arranged above the working surface (6) parallel thereto, and
- a positioning system (10) which can raise and lower the building plate (9) normal to the working surface and is designed to set the spacing between component (8) and conveyor belt (3).

7. 3D printer (1) according to one of Claims 1 to 6, wherein the manufacturing unit comprises at least two cleaning apparatuses (11) for cleaning the respectively associated raw material off from the component (8).

8. 3D printer (1) according to Claim 7, wherein the cleaning apparatuses (11) can be moved laterally along the surface of the component (8) by a drive system.

9. 3D printer (1) according to Claim 7 or 8, wherein a recycle device is provided for each of the cleaning apparatuses (11),
and wherein each recycle device (11) comprises a conveying device which is designed to recycle the recovered raw material into the respectively assigned dispenser (2).

10. Method for additively manufacturing a three-dimensional, multi-layer component (8) and for recovering non-consumed raw material, comprising the following steps:
- applying a layer of a raw material to a conveyor belt (3) by means of a dispenser (2), wherein the applied layer thickness of raw material corresponds at least to the desired layer thickness of a layer to be added to the component (8),
- transporting the conveyor belt (3) in the lateral direction with the layer of the raw material to a working surface (6),
- bringing the layer of the raw material into contact with a surface to be coated of the component (8) on the working surface (6) and curing a portion of the raw material in a structured manner in order to form a new structured layer of the component (8),
- raising the component (8) comprising the new layer from the working surface (6),
- transporting the residual raw material on the conveyor belt (3) in the lateral direction to a recovery apparatus (12),
- removing the residual raw material from the conveyor belt (3) with the aid of the recovery apparatus (12) and recycling the raw material to a dispenser (2),
- repeating the aforementioned method steps with a second raw material and a second dispenser (2), wherein a second recovery apparatus (12) is provided, such that the first and second raw material can each be selectively recycled into the corresponding dispenser (2).

11. Method according to Claim 10, wherein
- the working surface (6) has a window which is permeable to radiation and has, in terms of its dimensioning, at least the dimensions of the layer to be added,
- a building plate is positioned with the component (8) above the window,
- the building plate (9) is lowered normal to the window until the distance between the surface of the component (8) and the top side of the conveyor belt (3) corresponds to the desired layer thickness of the new structured layer to be added to the component (8),
- the raw material is structured and cured by means of irradiation of the multi-layer component (8) through the window to form a new layer, and
- the building plate is raised with the component (8) and the new layer adhering thereto from the conveyor belt (3) .

12. Method according to Claim 11, comprising the following subsequent steps:
- providing a cleaning apparatus (11) for cleaning raw material off from the component (8),
- removing the excess raw material from the surface of the component (8) by lateral movement of the cleaning apparatus (11) along the surface of the component (8),
- recycling the raw material into the dispenser (2) corresponding to the raw material by way of an associated recycle device.

## Revendications

1. Imprimante 3D (1) pour la fabrication additive d'un composant multicouche, comprenant
- au moins deux distributeurs (2) séparés, qui sont conçus pour revêtir une bande transporteuse (3) avec une matière première respectivement différente,
- une unité de fabrication qui est conçue pour que, dans l'unité de fabrication, au moins une partie de la matière première soit ajoutée au composant (8) sous forme de nouvelle couche,
- au moins deux dispositifs de récupération (12) séparés pour la récupération sélective de la matière première respectivement différente qui n'est pas consommée lors de l'ajout d'une couche au composant (8) et pour le recyclage de la matière première dans le distributeur associé (2) respectif,
- la bande transporteuse (3) qui est conçue pour transporter la matière première du distributeur (2) à l'unité de fabrication et ensuite au dispositif de récupération (12) dans la direction latérale.

2. Imprimante 3D (1) selon la revendication 1, dans laquelle la bande transporteuse (3) comprend un film transparent au rayonnement, des rouleaux rotatifs étant conçus pour déplacer le film.

3. Imprimante 3D (1) selon la revendication 2, dans laquelle le film peut circuler dans un circuit et peut ainsi être revêtu à nouveau.

4. Imprimante 3D (1) selon l'une quelconque des revendications 1 à 3, dans laquelle chacune des matières premières comprend une pâte comprenant une poudre soit céramique, soit métallique, soit organique, et un liant organique photopolymérisable.

5. Imprimante 3D (1) selon l'une quelconque des revendications 1 à 4, dans laquelle chaque distributeur (2) comprend un récipient pour stocker la matière première et un dispositif de revêtement pour revêtir la bande transporteuse (3) avec la matière première.

6. Imprimante 3D (1) selon l'une quelconque des revendications 1 à 5, dans laquelle l'unité de fabrication comprend les éléments suivants :
- une surface de travail (6) sur laquelle est guidée la bande transporteuse (3) et qui comprend une fenêtre qui est perméable au rayonnement,
- une source de rayonnement (7) agencée sous la fenêtre de manière à pouvoir exposer et donc durcir la matière première sur la bande transporteuse à travers la fenêtre et la bande transporteuse (3),
- une plaque de construction (9), au côté inférieur de laquelle adhère le composant (8), qui est agencée au-dessus de la surface de travail (6), parallèlement à celle-ci, et
- un système de positionnement (10) qui peut soulever et abaisser la plaque de construction (9) normalement à la surface de travail et qui est configuré pour régler la distance entre le composant (8) et la bande transporteuse (3).

7. Imprimante 3D (1) selon l'une quelconque des revendications 1 à 6, dans laquelle l'unité de fabrication comprend au moins deux dispositifs de nettoyage (11) pour nettoyer le composant (8) de la matière première associée respective.

8. Imprimante 3D (1) selon la revendication 7, dans laquelle les dispositifs de nettoyage (11) peuvent être déplacés latéralement le long de la surface du composant (8) par un système d'entraînement.

9. Imprimante 3D (1) selon la revendication 7 ou 8, dans laquelle un appareil de recyclage est prévu pour chacun des dispositifs de nettoyage (11), et dans laquelle chaque appareil de recyclage (11) comprend un appareil de transport conçu pour recycler la matière première récupérée dans le distributeur (2) associé respectif.

10. Procédé de fabrication additive d'un composant tridimensionnel multicouche (8) et de récupération de matière première non utilisée, comprenant les étapes suivantes :
- l'application d'une couche d'une matière première sur une bande transporteuse (3) au moyen d'un distributeur (2), l'épaisseur de couche de matière première appliquée correspondant au moins à l'épaisseur de couche souhaitée d'une couche à ajouter au composant (8),
- le transport de la bande transporteuse (3) dans la direction latérale avec la couche de matière première sur une surface de travail (6),
- la mise en contact de la couche de matière première avec une surface à revêtir du composant (8) sur la surface de travail (6) et le durcissement structuré d'une partie de la matière première pour former une nouvelle couche structurée du composant (8),
- le soulèvement du composant (8) comprenant la nouvelle couche de la surface de travail (6),
- le transport du reste de la matière première sur la bande transporteuse (3) dans une direction latérale vers un dispositif de récupération (12),
- l'enlèvement du reste de la matière première de la bande transporteuse (3) à l'aide du dispositif de récupération (12) et le recyclage de la matière première vers un distributeur (2),
- la répétition des étapes de procédé susmentionnées avec une deuxième matière première et un deuxième distributeur (2), un deuxième dispositif de récupération (12) étant prévu, de telle sorte que la première et la deuxième matière première peuvent chacune être recyclées de manière sélective dans le distributeur (2) correspondant.

11. Procédé selon la revendication 10, dans lequel
- la surface de travail (6) présente une fenêtre qui est transparente au rayonnement et dont les dimensions sont au moins égales à celles de la couche à ajouter,
- une plaque de construction avec le composant (8) est positionnée au-dessus de la fenêtre,
- la plaque de construction (9) est abaissée normalement à la fenêtre jusqu'à ce que la distance entre la surface du composant (8) et le côté supérieur de la bande transporteuse (3) corresponde à l'épaisseur de couche souhaitée de la nouvelle couche structurée à ajouter au composant (8),
- la matière première est structurée et durcie en une nouvelle couche par exposition du composant multicouche (8) à un rayonnement à travers la fenêtre, et
- la plaque de construction avec le composant (8) et la nouvelle couche qui y adhère est soulevée de la bande transporteuse (3).

12. Procédé selon la revendication 11, qui comprend les étapes ultérieures suivantes :
- la fourniture d'un dispositif de nettoyage (11) pour nettoyer le composant (8) de la matière première,
- l'enlèvement de la matière première en excès de la surface du composant (8) en déplaçant latéralement le dispositif de nettoyage (11) le long de la surface du composant (8),
- le recyclage de la matière première dans le distributeur (2) correspondant à la matière première par un appareil de recyclage associé.
